Europäisches Patentamt

European Patent Office

Office européen des brevets

(19)

(11) **EP 1 411 362 B1**

(12) **FASCICULE DE BREVET EUROPEEN**

(45) Date de publication et mention
de la délivrance du brevet:
**29.06.2005 Bulletin 2005/26**

(51) Int Cl.⁷: **G01R 31/02**, H04L 12/26

(21) Numéro de dépôt: **03103742.7**

(22) Date de dépôt: **09.10.2003**

(54) **Procédé de détection de défaut de blindage d'un câble multifilaire**

Verfahren zur Erfassung eines Abschirmungsfehlers eines Mehrleiterkabels

Procedure for detecting a shielding fault in a multiconductor cable

(84) Etats contractants désignés:
**AT BE BG CH CY CZ DE DK EE ES FI FR GB GR
HU IE IT LI LU MC NL PT RO SE SI SK TR**

(30) Priorité: **11.10.2002 FR 0212671**

(43) Date de publication de la demande:
**21.04.2004 Bulletin 2004/17**

(73) Titulaire: **AIRBUS FRANCE**
**31060 Toulouse (FR)**

(72) Inventeurs:
• **Gambardella, Eddie**
**31700 Blagnac (FR)**

• **Flourens, Franck**
**31500, Toulouse (FR)**

(74) Mandataire: **Poulin, Gérard et al**
**BREVALEX**
**3, rue du Docteur Lancereaux**
**75008 Paris (FR)**

(56) Documents cités:
**US-A- 3 711 767     US-A- 6 002 671**

• **DATABASE WPI Section EI, Week 198732
Derwent Publications Ltd., London, GB; Class
S01, AN 1987-227170 XP002245404 & SU 1 278
737 A (SEIDER) 23 décembre 1986 (1986-12-23)**

**Description**

**DOMAINE TECHNIQUE**

La présente invention concerne un procédé de détection de défaut de blindage d'un câble multifilaire, utilisable notamment sur un avion.

**ETAT DE LA TECHNIQUE ANTERIEURE**

Les réseaux de communications (Ethernet, ATM,...) utilisant des liaisons, de préférence en cuivre, sont sensibles aux agressions électromagnétiques et sont limités en terme de rayonnement électromagnétique.

Pour résoudre de tels problèmes, on a recours à des liaisons blindées. Mais, la vérification de l'intégrité du blindage de telles liaisons est difficile et souvent coûteuse.

Un document, de l'art antérieur, référencé [1] en fin de description, décrit une méthode réflectométrique de vérification de l'intégrité d'un blindage d'un câble qui est une méthode appliquée à une paire de fils de ce câble. Cette méthode donne des résultats peu précis lorsque seul le blindage est abîmé.

Un document référencé [2] décrit une méthode de vérification de l'intégrité d'un blindage de câble basée sur une mesure d'impédance de transfert. Cette méthode est, de loin, la plus répandue. Elle présente l'inconvénient de mobiliser un matériel lourd et des précautions de mise en oeuvre importantes. De plus, elle nécessite la mesure de la tension d'un fil dans le câble, ce qui nécessite la plupart du temps de modifier l'installation.

Un document référencé [3] décrit un capteur de test de résistance de boucle pour surveiller l'intégrité du blindage d'un câble. Ce capteur utilise une sonde de courant de commande possédant deux enroulements, un de ces enroulements étant utilisé pour mesurer une tension injectée sur ledit blindage. Dans le cas du test d'un système de câblage d'un avion, le câble électrique et la structure de l'avion auquel il est fixé, forment une boucle continue à travers laquelle un courant peut circuler. Une tension électrique alternative est induite dans cette boucle au moyen dudit capteur, et le courant de boucle est mesuré par celui-ci. Le rapport complexe du courant induit dans la boucle et de la tension de boucle donne l'impédance de boucle dont la partie réelle résistive est une indication de l'intégrité du blindage électrique et de sa connexion à la structure de l'avion.

Un tel capteur n'offre pas une précision suffisante pour des applications Ethernet (hautes fréquences). En effet, ce capteur risque de ne pas détecter une très faible augmentation de la résistance de boucle, laquelle peut néanmoins avoir un impact important sur la qualité de protection du blindage. Ladite très faible augmentation de la résistance de boucle peut notamment se produire dans le cas d'un câble de grande longueur ayant une résistance de boucle élevée ou dans le cas de blessures dudit blindage. D'autre part, un tel capteur ne permet pas de mesure dynamique car dans ce cas le courant correspondant au transfert de données dans ce câble perturberait la mesure.

L'invention a pour objet d'offrir une meilleure précision de détection de défaut de blindage d'un câble multifilaire et de simplifier et permettre une mesure dynamique simplifiée.

**EXPOSÉ DE L'INVENTION**

La présente invention propose, à cet effet, un procédé de détection de défaut de blindage d'un câble multifilaire faisant partie d'un réseau de communication, au cours du fonctionnement opérationnel dudit réseau, ledit câble véhiculant un signal multitrames S(t) caractérisé en ce qu'il comprend les étapes suivantes :

- on injecte un signal perturbateur I(t) dans ledit câble via une pince à injection, qui est en boucle magnétique qui peut être ouverte ou fermée autour du câble et dans laquelle on injecte un signal alternatif, pendant un temps déterminé T,

- à la réception du signal S(t) par un équipement, on compte le nombre N de trames en défaut pendant la durée d'injection du signal perturbateur I(t),

- on détermine l'existence d'une défaillance éventuelle du blindage de ce câble lorsque l'on a l'inégalité suivante : $N/T \leq TEP_{max}$, $TEP_{max}$ étant le taux d'erreur de paquet maximum à garantir.

On peut avoir $TEP_{max}=0$. Le réseau de communication peut être un réseau Ethernet. Le nombre N peut être le nombre de trames erreurs, qui comprend notamment les erreurs CRC, les trames trop courtes, et les trames manquantes. Le nombre N peut également être comptabilisé dans la partie MIB de différents équipements du réseau.

Avantageusement, on a l'inégalité suivante : $\frac{I1}{ATT_{min}} < I < \frac{I1}{ATT_{max}}$, avec :

- I1 : le niveau du signal perturbateur I(t) qui perturbe le signal S(t) en l'absence de la protection du blindage,

- $ATT_{min}$ : l'atténuation minimum du blindage, qui est nécessaire pour que la perturbation induite sous le blindage soit inférieure à I1, compte-tenu de l'agression extérieure maximale attendue,

- $ATT_{max}$ : l'atténuation normale du blindage.

Le signal perturbateur I(t) peut être similaire au signal S(t) véhiculé sur le câble. Il peut également présenter, au moins, une fréquence préalablement identifiée comme perturbant tout particulièrement le signal S(t).

Le procédé de l'invention est utilisable notamment sur un avion.

## BRÈVE DESCRIPTION DES DESSINS

La figure 1 illustre le schéma de principe d'une installation permettant de mettre en oeuvre le procédé de l'invention.

La figure 2 illustre un exemple de réalisation de l'invention.

## EXPOSÉ DÉTAILLÉ DE MODES DE RÉALISATION PARTICULIERS

Le procédé de l'invention propose d'utiliser la sensibilité de signaux multitrames S(t) véhiculés dans un câble multifilaire d'un réseau de communication, au cours du fonctionnement opérationnel de ce réseau.

Ce procédé comprend les étapes suivantes :

- on injecte un signal perturbateur I(t) dans ledit câble via une pince à injection pendant un temps déterminé T,
- à la réception de ce signal par un équipement, on compte le nombre N de trames en défaut pendant la durée de l'injection du signal perturbateur,
- on détermine l'existence d'une défaillance éventuelle du blindage de ce câble lorsque l'on a l'inégalité suivante : $N/T \leq TEP_{max}$, $TEP_{max}$ étant le taux d'erreur de paquet maximum à garantir, qui peut être égal à zéro.

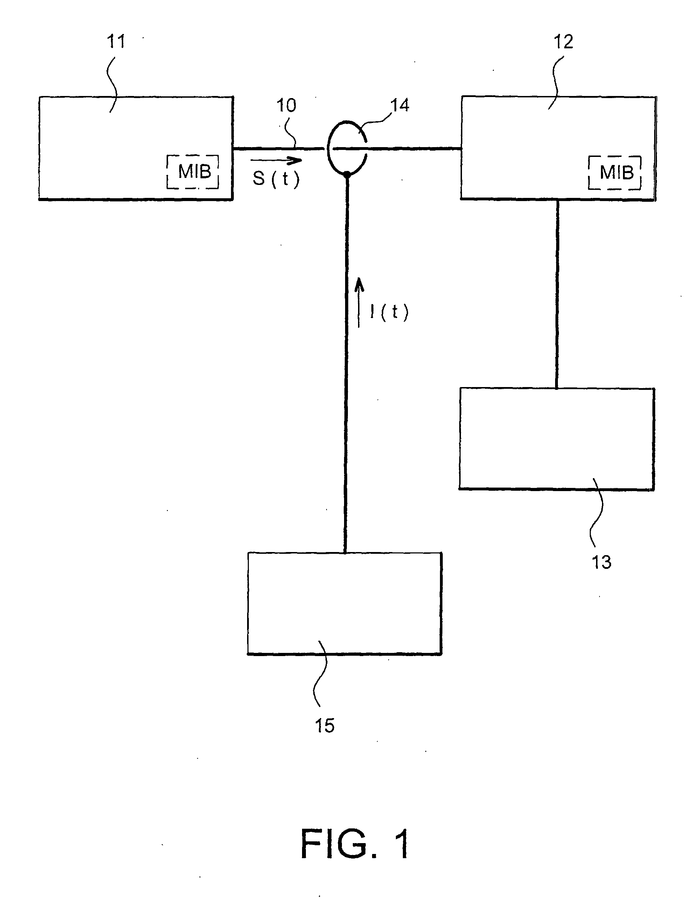

La figure 1 illustre le schéma de principe d'une installation, par exemple un avion, permettant de mettre en oeuvre ce procédé. Le signal S(t) est véhiculé sur un câble multifilaire 10 entre un équipement abonné 11 et un interface 12 auquel est relié un terminal de contrôle 13. Une pince d'injection 14 permet d'injecter dans le câble 10 un signal I(t) issu d'un générateur 15. Le terminal 13 permet de vérifier le nombre de trames perdues pendant la durée de l'injection du signal perturbateur.

Le comptage des N trames en défaut pendant l'injection, peut être réalisé de différentes manières.

Ce comptage peut être basé sur un comptage du nombre de trames en erreur, comprenant, notamment, les erreurs CRC ("contrôle de redondance cyclique"), les trames trop courtes, les trames manquantes.

Pour un réseau de communication de type Ethernet, ce nombre N est, en général, comptabilisé naturellement dans la partie MIB ("management information base") de l'équipement abonné 11 ou de l'interface 12. Le terminal de contrôle 13 ne fait qu'afficher les informations de la partie MIB de l'équipement 12.

L'amplitude I du signal perturbateur I(t) est choisie de façon à ce que :

- le protocole de transmission basé sur le signal S(t) véhiculé sur le câble 10 soit perturbé, des pertes de trames étant détectées en réception si le blindage de ce câble 10 est abîmé,

- ce protocole de transmission ne soit pas perturbé si le blindage de ce câble 10 est indemne.

On considère :

- I1 : le niveau du signal perturbateur I(t) qui perturbe le signal S(t) en l'absence de la protection du blindage,
- $ATT_{min}$ : l'atténuation minimum du blindage, qui est nécessaire pour que la perturbation induite sous le blindage soit inférieure à I1, compte-tenu de l'agression extérieure maximale attendue, qui est spécifiée par les normes internationales,
- $ATT_{max}$ : l' atténuation normale du blindage.

Le blindage du câble 10 est considéré comme étant dégradé lorsque son atténuation est comprise entre $ATT_{min}$ et $ATT_{max}$. Si l'on considère les relations :

- $I.ATT_{max} < I1$ : pas de perturbation si le blindage est indemne,
- $I.ATT_{min} > I1$ : une dégradation du blindage induit une perte de trames, on a alors :

$$\frac{I1}{ATT_{min}} < I < \frac{I1}{ATT_{max}}$$

Le signal perturbateur I(t) peut présenter différentes formes :

- Il peut être similaire au signal S(t) véhiculé sur le câble 10. Ce peut être, par exemple, un signal I(t) Ethernet à 100 Mbits/seconde, tout comme le signal S(t).
- Il peut présenter une ou plusieurs fréquences, qui peuvent avoir été préalablement identifiées comme perturbant tout particulièrement le signal S(t). Ces fréquences se situent, généralement, au maximum de densité spectrale du signal S(t), par exemple, à 31,25Mhz pour un signal Ethernet S(t) 100Mbits/seconde.

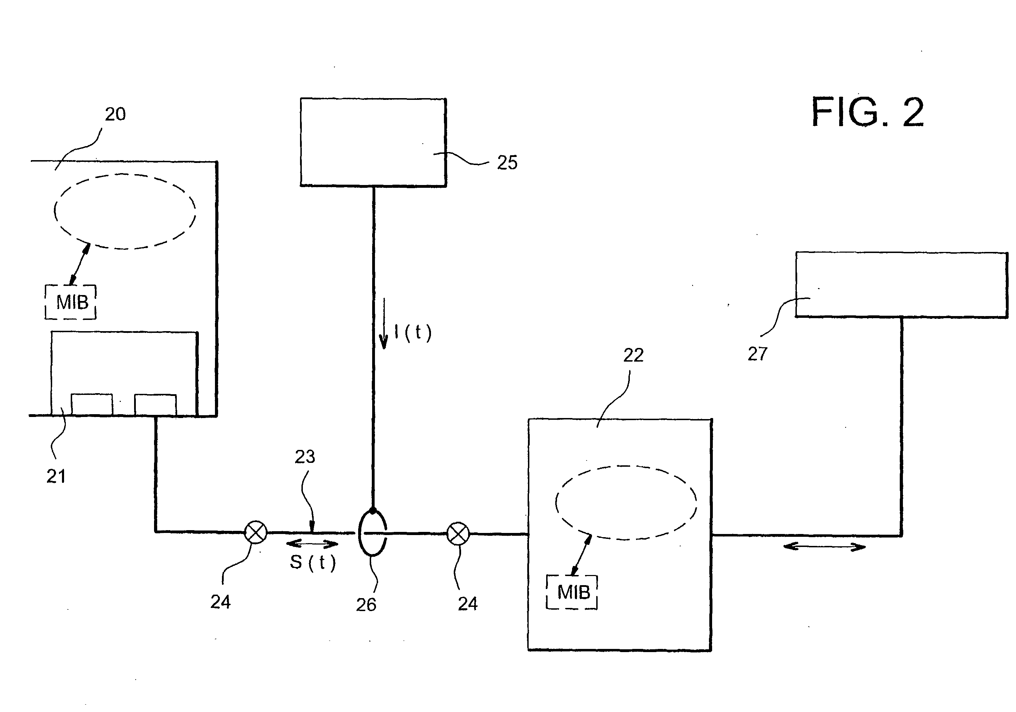

La figure 2 illustre un exemple de mode de réalisation dans la détection d'un défaut sur un lien du réseau AFDX (ou "Avionics Full Duplex Ethernet").

Sur cette figure sont représentés :

- un équipement abonné AFDX 20, avec un système d'extrémité AFDX 21,
- un commutateur AFDX 22,
- un câble "star quad" blindé 23 reliant ce système 21 et ce commutateur 22,
- des connecteurs 24 à base de contact "quadrax" disposé sur ce câble blindé 23,
- un générateur de courant 25 relié à une pince d'injection 26 calibrée disposée autour de ce câble 23,
- un gestionnaire de réseau 27 en liaison avec le commutateur 22 au moyen d'un protocole SNMP ("Simple Network Management Protocol").

Le protocole SNMP permet au gestionnaire de réseau 27 de connaître l'état de l'équipement d'un abonné 20 sur le réseau. L'agent SNMP est un module logiciel dans un équipement (équipement 20 ou commutateur 22) qui permet de répondre aux requêtes du gestionnaire 27. Il utilise la base de données MIB pour répondre à ces requêtes.

Les signaux représentés sur cette figure sont les suivants.

- S(t) : signal AFDX (Ethernet full duplex 100 Mbit/s)
- I(t) : signal perturbateur sinusoïdal à 31,25 MHz d'amplitude 300 mA (on suppose ici le rapport d'injection égal à 1)
- |1 = 15 mA, ATTmin = 0,1, ATTmax = 0,05
- T : 2 secondes.

Le gestionnaire de réseau 27 récupère l'objet afdxMACCRerrors (nombre de trames en erreur CRC) dans les parties MIB du commutateur AFDX 22 et de l'abonné AFDX 20 via le protocole SNMP.

Le lien est considéré sans défaut si aucune erreur n'est survenue ni du côté abonné 20, ni du côté commutateur AFDX 22.

REFERENCES

[1] "High Accuracy Location of Faults on Electrical Lines Using Digital Signal Processing" de Leo P. Van Biesen, J. Renneboog (IEEE Transactions on Instrumentation and measurement. Vol. 39, N°1, Février 1990).

[2] "Fault detection techniques for complex cable shield topologies" de Kurt H. Coonrod (Septembre 1994, Philips Laboratory, ref. PL-TR-93-1111).

[3] EP 0 936 469.

**Revendications**

1. Procédé de détection de défaut de blindage d'un câble multifilaire faisant partie d'un réseau de communication, au cours du fonctionnement opérationnel dudit réseau, ledit câble (10) véhiculant un signal multitrames S(t), **caractérisé en ce qu'**il comprend les étapes suivantes :

   - on injecte un signal perturbateur I(t) dans ledit câble via une pince à injection (14) pendant un temps déterminé T,
   - à la réception du signal S(t) par un équipement (12), on compte le nombre N de trames en défaut pendant la durée d'injection du signal perturbateur I(t),
   - on détermine l'existence d'une défaillance éventuelle du blindage de ce câble (10) lorsque l'on a l'inégalité suivante : $N/T \leq TEP_{max}$, $TEP_{max}$ étant le taux d'erreur de paquet maximum à garantir.

2. Procédé selon la revendication 1, dans lequel on a : $TEP_{max} = 0$.

3. Procédé selon l'une quelconque des revendications précédentes, dans lequel le réseau de communication est un réseau Ethernet.

4. Procédé selon l'une quelconque des revendications précédentes, dans lequel N est le nombre de trames erreurs, qui comprend notamment les erreurs CRC, les trames trop courtes, et les trames manquantes.

5. Procédé selon l'une quelconque des revendications précédentes, dans lequel le nombre N est comptabilisé dans la partie MIB de différents équipements (11, 12) du réseau.

6. Procédé selon l'une quelconque des revendications précédentes, dans lequel on a l'inégalité suivante : $\frac{I1}{ATT_{min}} < I < \frac{I1}{ATT_{max}}$ , avec :

   - I1 : le niveau du signal perturbateur I(t) qui perturbe le signal S(t) en l'absence de la protection du blindage,
   - $ATT_{min}$ : l'atténuation minimum du blindage, qui est nécessaire pour que la perturbation induite sous le blindage soit inférieure à I1, compte-tenu de l'agression extérieure maximale attendue,
   - $ATT_{max}$ : l'atténuation normale du blindage.

7. Procédé selon l'une quelconque des revendications précédentes, dans lequel le signal perturbateur I(t) est similaire du signal S(t) véhiculé sur le câble.

8. Procédé selon l'une quelconque des revendications précédentes, dans lequel le signal perturbateur I(t) présente au moins une fréquence préalablement identifiée comme perturbant tout particulièrement le signal S(t).

**Patentansprüche**

1. Verfahren zur Erfassung eines Abschirmungsfehlers eines Teil eines Kommunikationsnetzes bildenden Mehrfaserkabels während des Betriebs des Netzes, wobei das Kabel (10) ein Mehrblocksignal S(t) transportiert, **dadurch gekennzeichnet, dass** es die folgenden Schritte umfasst:

- ein Störsignal I(t) wird über eine Einspeiseklemme (14) während einer vorbestimmten Zeit T in das Kabel eingespeist,
- bei Empfang des Signals S(t) durch eine Einrichtung (12) wird die Anzahl N von fehlerhaften Frames bzw. Datenblöcken während der Einspeisedauer des Störsignals I(t) gezählt,
- die Existenz eines eventuellen Mangels der Abschirmung dieses Kabels (10) wird bestimmt, wenn die folgende Ungleichung: $N/T \leq TEP_{max}$ besteht, wobei $TEP_{max}$ die maximale garantierbare Datenpaket-Fehlerquote ist.

2. Verfahren nach Anspruch 1, wobei $TEP_{max}$ = 0 beträgt.

3. Verfahren nach einem der vorangehenden Ansprüche, wobei das Kommunikationsnetz ein Ethernet-Netz ist.

4. Verfahren nach einem der vorangehenden Ansprüche, wobei N die Anzahl fehlerhafter Frames bzw. Datenblöcke ist, die insbesondere CRC-Fehler, zu kurze Datenblöcke und fehlende Datenblöcke umfasst.

5. Verfahren nach einem der vorangehenden Ansprüche, wobei die Zahl N im MIB-Teil von verschiedenen Einrichtungen (11,12) des Netzes registriert wird.

6. Verfahren nach einem der vorangehenden Ansprüche, bei dem folgende Ungleichung besteht: $\frac{I1}{ATT_{max}} < I < \frac{I1}{ATT_{min}}$, mit:

- I1: der Pegel des Störsignals I(t), welches das Signal S(t) bei fehlendem Schutz der Abschirmung stört,
- $ATT_{min}$ : die minimale Dämpfung der Abschirmung, die notwendig ist, damit die unter der Abschirmung induzierte Störung, unter Berücksichtigung der maximalen zu erwartenden äußeren Aggression, geringer als I1 ist,
- $ATT_{max}$ : die normale Dämpfung der Abschirmung.

7. Verfahren nach einem der vorangehenden Ansprüche, wobei das Störsignal I(t) ähnlich dem über das Kabel transportierten Signal S(t) ist.

8. Verfahren nach einem der vorangehenden Ansprüche, wobei das Störsignal I(t) zumindest eine im voraus als insbesondere das Signal S(t) störend identifizierte Frequenz aufweist.

**Claims**

1. Method for detection of a shielding fault in a multiwire cable forming part of a communication network, during functional operation of the said network, the said cable (10) transferring a multiframe signal S(t), **characterized in that** it comprises the following steps:

- a disturbing signal I(t) is injected into the said cable through an injection clamp (14) for a determined time T,
- when an item of equipment (12) receives the signal S(t), the number N of frames in fault during the injection period of the disturbing signal I(t) is counted,
- it is decided that there is a shielding fault in this cable (10) if $N/T \leq TEP_{max}$, where $TEP_{max}$ is the maximum packet error rate to be guaranteed.

2. Method according to claim 1, in which $TEP_{max}$ is equal to 0.

3. Method according to any one of the above claims, in which the communication network is an Ethernet network.

4. Method according to any one of the above claims, in which N is the number of error frames, that in particular includes CRC errors, frames that are too short, and missing frames.

5. Method according to any one of the above claims, in which the number N is included in the MIB part for different network equipment (11, 12).

6. Method according to any one of the above claims, in which the following relation is true:

$$\frac{I1}{ATT_{min}} < I < \frac{I1}{ATT_{max}} ,$$

where:

- I1: the level of the disturbing signal I(t) that disturbs the signal S(t) if there is no shielding protection,
- $ATT_{min}$: the minimum attenuation of the shielding necessary for the disturbance induced under the shielding to be less than I1, taking account of the expected maximum external aggression,
- $ATT_{max}$: normal attenuation of the shielding.

7. Method according to any one of the above claims, in which the disturbing signal I(t) is similar to the signal S(t) transferred on the cable.

8. Method according to any one of the above claims, in which the disturbing signal I(t) has at least one frequency previously identified as particularly disturbing the signal S(t).

FIG. 1

FIG. 2

EP 1 411 362 B1